# EUROPEAN PATENT APPLICATION

(11) **EP 1 096 042 A1**
(43) Date of publication of application: **02.05.2001**
(21) Application number: 00122969.9
(22) Date of filing: 23.10.2000
(51) Int. Cl.: C30B 25/02, C30B 29/16

(54) **Method for fabricating a semiconductor structure including a metal oxide interface with silicon**

(30) Priority: 25.10.1999 US 425945
(71) Applicant: MOTOROLA, INC., Schaumburg, IL 60196 (US)
(72) Inventor: Ramdani, Janal, Gilbert, Arizona 85233 (US); Droopad, Ravindranath, Chandler, Ariona 85226 (US); Yu, Zhiyi Jimmy, Gilbert, Arizona 85233 (US)
(74) Representative: Gibson, Sarah Jane

(57) **Abstract**

A method of fabricating a semiconductor structure including the steps of providing a silicon substrate (10) having a surface (12), forming on the surface (12) of the silicon substrate (10), by atomic layer deposition (ALD), a seed layer (20;20') characterised by a silicate material and forming, by atomic layer deposition (ALD) one or more layers of a high dielectric constant oxide (40) on the seed layer (20;20').

## Description

### Field of Invention

The present invention relates in general to a method for fabricating a semiconductor structure including a silicate interface between a silicon substrate and metal oxides, and more particularly to a method for fabricating an interface including a seed layer utilizing atomic layer deposition or atomic layer epitaxy.

### Background of the Invention

A stable silicon (Si) surface is most desirable for subsequent epitaxial growth of metal oxide thin films on silicon for numerous device applications, e.g., ferroelectrics or high dielectric constant oxides for non-volatile high density memory and next generation MOS devices. It is pivotal to establish a stable transition layer on the Si surface for the subsequent growth of high-k metal oxides.

Some reported growth of these oxides, such as BaO and BaTiO₃ on Si (100) were based on a BaSi₂ (cubic) template by depositing one fourth monolayer of Ba on Si (100) using molecular beam epitaxy at temperatures greater than 850°C. See for example: R. McKee et al., *Appl. Phys. Lett*. 59(7), pp. 782-784 (12 August 1991); R. McKee et al., *Appl. Phys. Lett*. 63(20), pp. 2818-2820 (15 November 1993); R. McKee et al., *Mat. Res. Soc. Symp. Proc*., Vol. 21, pp. 131-135 (1991); U.S. Patent No. 5,225,031, issued July 6, 1993, entitled "PROCESS FOR DEPOSITING AN OXIDE EPITAXIALLY ONTO A SILICON SUBSTRATE AND STRUCTURES PREPARED WITH THE PROCESS"; and U.S. Patent No. 5,482,003, issued January 9, 1996, entitled "PROCESS FOR DEPOSITING EPITAXIAL ALKALINE EARTH OXIDE ONTO A SUBSTRATE AND STRUCTURES PREPARED WITH THE PROCESS". A strontium suicide (SrSi₂) interface model with a c(4x2) structure was proposed. See for example: R. McKee et al., Phys. Rev. Lett. 81(14), 3014 (5 October, 1998). However, atomic level simulation of this proposed structure indicates that it likely is not stable at elevated temperatures.

Growth of SrTiO₃ on silicon (100) using an SrO buffer layer has been accomplished. See for example: T. Tambo et al., *Jpn. J. Appl. Phys*., Vol. 37 (1998), pp. 4454-4459. However, the SrO buffer layer was thick (100 Å), thereby limiting application for transistor films, and crystallinity was not maintained throughout the growth.

Furthermore, SrTiO₃ has been grown on silicon using thick oxide layers (60-120 Å) of SrO or TiOₓ. See for example: B. K. Moon et al., *Jpn. J. Appl. Phys*., Vol. 33 (1994), pp. 1472-1477. These thick buffer layers would limit the application for transistors.

High-k oxides are of great importance for the next generation MOSFET applications. Typically, in all of these known structures, they are prepared using molecular beam epitaxy (MBE), pulsed laser deposition (PLD), sputtering, and/or metal-organic chemical vapor deposition (MOCVD). In these types of methods of preparation, it is difficult to control the silicon oxide interface to achieve low density of interfacial traps, low leakage current, and for thickness and composition uniformity over large areas, such as 8" and above, and conformity over trenches. Accordingly, there is a need for a method that provides for a better interface between a silicon substrate and the metal oxide layer, that is simple to manufacture, controllable, has suppressed fringing effects in MOSFET devices, and suitable for mass production.

Accordingly, it is a purpose of the present invention to provide for a method of fabricating a thin, stable silicate interface with silicon.

It is yet another purpose of the present invention to provide for a method of fabricating a semiconductor structure including a metal oxide interface with silicon that is reliable and amenable to high throughput manufacturing.

### Summary of the Invention

The above problems and others are at least partially solved and the above purposes and others are realized in a method of fabricating a semiconductor structure including the steps of providing a silicon substrate having a surface, forming on the surface of the silicon substrate, by atomic layer deposition (ALD), a seed layer characterised by a silicate material and forming, by atomic layer deposition (ALD) one or more layers of a high dielectric constant oxide on the seed layer.

### Brief Description of the Drawings

Referring to the drawings:
FIG. 1 illustrates a cross-sectional view of a first embodiment of a clean semiconductor substrate having a plurality of oxide layers formed thereon and in accordance with the present invention;
FIG. 2 illustrates a cross-sectional view of a semiconductor substrate having an interface seed layer formed of a silicate layer utilizing atomic layer deposition in accordance with the present invention;
FIG. 3 illustrates a cross-sectional view of second embodiment of a clean semiconductor structure having a hydrogen layer formed thereon and in accordance with the present invention;
FIG. 4 illustrates a cross-sectional view of a semiconductor structure having an oxide layer formed thereon and in accordance with the present invention;
FIG. 5 illustrates a cross-sectional view of a semiconductor substrate having an interface seed layer formed of a silicate layer utilizing atomic layer deposition in accordance with the present invention;
FIG. 6 illustrates the method of forming the interface seed layer utilizing atomic layer deposition in accordance with the present invention;
FIG. 7 illustrates a cross-sectional view of a semiconductor substrate having a high dielectric constant metal oxide layer formed on the structure illustrated in FIGs. 2 and 5 utilizing atomic layer deposition in accordance with the present invention; and
FIG. 8 illustrates the method of forming the high dielectric constant metal oxide layer utilizing atomic layer deposition in accordance with the present invention.

### Detailed Description of the Preferred Embodiment

This disclosure teaches a method of fabricating a high dielectric constant (high-k) metal oxide having an interface with a silicon substrate. The process is based on the use of atomic layer deposition (ALD) to form a stable silicate seed layer necessary for the subsequent growth of alkaline-earth metal oxide layers. Accordingly, disclosed is a new method of growing a seed layer and metal oxide layer utilizing atomic layer deposition.

To form the novel interface between a silicon (Si) substrate and one or more layers of a high dielectric constant (high-k) metal oxide, two specific approaches utilizing atomic layer deposition may be used dependent upon the substrate. A first example will be provided for starting with a Si substrate having silicon dioxide (SiO₂) formed on the surface. The silicon dioxide is disclosed as formed as a native oxide, or by utilizing thermal, or chemical techniques. SiO₂ is amorphous rather than single crystalline and it is desirable for purposes of growing the seed layer material on the substrate to create the interfacial layer. The second example will be provided for starting with a Si substrate which undergoes hydrogen (H) passivation, thereby having formed on the surface a layer of hydrogen (H).

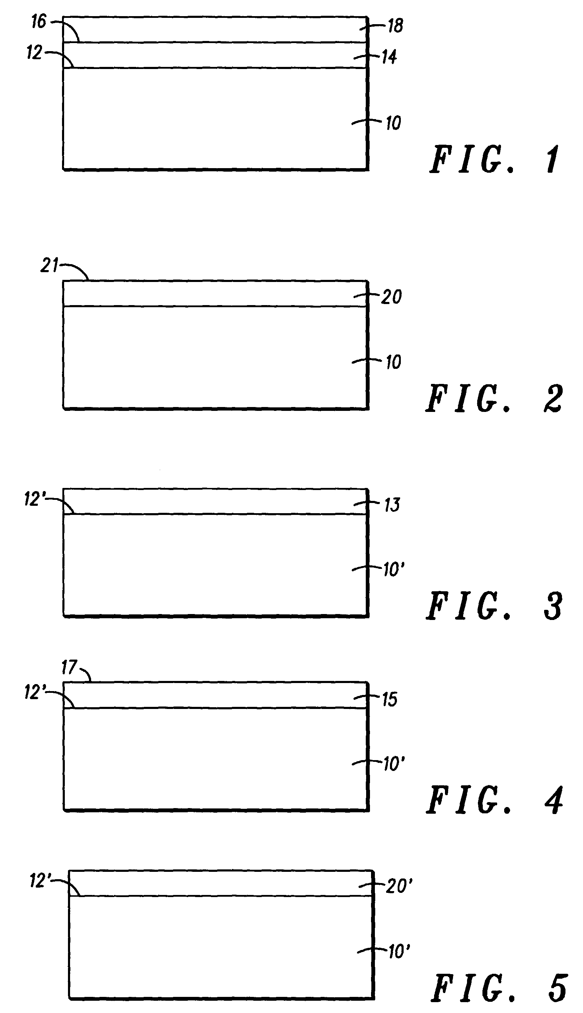

Turning now to the drawings in which like elements are designated with like numbers throughout the FIGs., FIG. 1 illustrates a Si substrate 10 having a surface 12, and a layer 14 of SiO₂ thereupon. In this particular embodiment, layer 14 of SiO₂ naturally exists (native oxide) once the silicon substrate 10 is exposed to air (oxygen). Alternatively, layer 14 of SiO₂ may be formed purposely in a controlled fashion well known in the art, e.g., thermally by applying oxygen onto the surface 12 at a high temperature, or chemically using a standard chemical etch process. Layer 14 is formed with a thickness in a range of 5-100Å thick, and more particularly with a thickness in a range of 10-25Å.

A novel seed layer (discussed presently) is formed utilizing atomic layer deposition. First, a thin layer, less than 20Å, of a metal oxide 18, such as zirconium oxide (ZrO₂), hafnium oxide (HfO₂), strontium oxide (SrO₂), or the like, is deposited onto surface 16 of layer 14 of SiO₂ using chloride or a β-Diketonate precursor and oxygen (O₂), water (H₂O), nitrous oxide (N₂O), or nitric oxide (NO) at a relatively low temperature, such as less than 600°C. More particularly, Si substrate 10 and the amorphous SiO₂ layer 14 are heated to a temperature below the sublimation temperature of the SiO₂ layer 14, generally below 900°C, and in a preferred embodiment below 600°C prior to the deposition of metal oxide 18.

Next, the temperature of substrate 10 is then raised above 600°C in order for the layer 18 metal oxide (MOₓ) and the layer 14 of SiO₂ to react to form a seed layer 20 of MSiOₓ (silicate), as illustrated in FIG. 2.

This step provides for the formation of a stable silicate on the silicon substrate, more particularly the formation of seed layer 20. The thickness of silicate, or seed, layer 20 is approximately a few monolayers, and the same thickness of the SiO₂ layer 14, more specifically in the range of 5-100Å, with a preferred thickness in the range of 10-25Å. In this particular embodiment, the application of metal oxide 18 to the surface 16 of layer 14 and subsequent flushing with nitrogen (N₂), argon (Ar), or helium (He), and heating causes a chemical reaction, forming hafnium silicon oxide (HfSiO₄), zirconium silicon oxide (ZrSiO₄), strontium silicon oxide (SrSiO₄), or the like, as seed layer 20. Monitoring of the semiconductor structure can be accomplished utilizing any surface sensitive technique, such as reflection difference spectroscopy, spectroscopic ellipsometry, or the like wherein the surface is monitored by in situ techniques.

It should be understood by those skilled in the art that the temperatures given for these processes are recommended for the particular embodiment described, but the invention is not limited to a particular temperature or pressure range.

In an alternative embodiment, and as illustrated in FIGs. 3-6, disclosed is Si substrate 10' having a surface 12', having undergone hydrogen (H) passivation, thereby having a layer 13 of hydrogen (H) formed thereon. It should be noted that all components of FIGs. 1 and 2 that are similar to components of the FIGs. 3-5, are designated with similar numbers, having a single prime added to indicate the different embodiment. In this particular embodiment, layer 13 of hydrogen (H) is formed in a controlled fashion by hydrogen passivation techniques.

A novel seed layer (discussed presently) is formed utilizing atomic layer deposition. First, layer 13 of hydrogen (H) is desorbed from surface 12' at a high temperature, preferably in excess of 300°C. Next, surface 12' of the Si substrate 10' is exposed to a Si precursor, such as silane (SiH₄), disilane (SiH₆), or the like, and a metal precursor, such as hafnium (Hf), strontium (Sr), zirconium (Zr), or the like, generally referenced 15 of FIG. 4, during a time equal to T1, as shown in FIG. 6, referenced 30. Substrate 10' is exposed to the precursors at a temperature of generally between 100°C-500°, and in a preferred embodiment at a temperature of 250°C and at an atmospheric pressure of 0.5mTorr. Once the precursors are deposited, a surface 17 is flushed 32 with an inert gas, such as argon (Ar), nitrogen (N₂), or helium (He), for a time, T2, as illustrated in FIGs. 4 and 6 to remove any excess material. The stack is then exposed 34 to oxygen (O) with or without plasma, water (H₂O), nitrous oxide (N₂O), or nitric oxide (NO) for a time, T3, to oxidize layer 15 of Si and metal, thereby forming seed layer 20', generally similar to seed layer 20 of FIG. 2. Finally, seed layer 20' is flushed 36, as illustrated in FIG. 6, with argon (Ar), nitrogen (N₂) or helium (He) to eliminate any excess oxygen (O).

This step provides for the formation of a stable silicate on the silicon substrate which has been hydrogen passivated, more particularly the formation of seed layer 20'. The thickness of seed layer 20' is approximately a few monolayers, more specifically in the range of 5-100Å, with a preferred thickness in the range of 10-25Å. In this particular embodiment, the atomic layer deposition is repeated for a few cycles, preferably 4-5 cycles, to form a few monolayers. Thus, a chemical reaction takes place forming hafnium silicon oxide (HfSiO₄), zirconium silicon oxide (ZrSiO₄), strontium silicon oxide (SrSiO₄), or the like, as the seed layer 20'.

It should be understood that the component (x), where x= 0 to 1 in layer 20', having the composition of MₓSi₁₋ₓO, can be adjusted using precursor flows of metal and silicon mixed prior to the introduction in the reaction chamber for better control. More particularly, a graded composition could be used whereby, the resultant final layer deposition using ALD renders a solely metal oxide layer, containing no silicon.

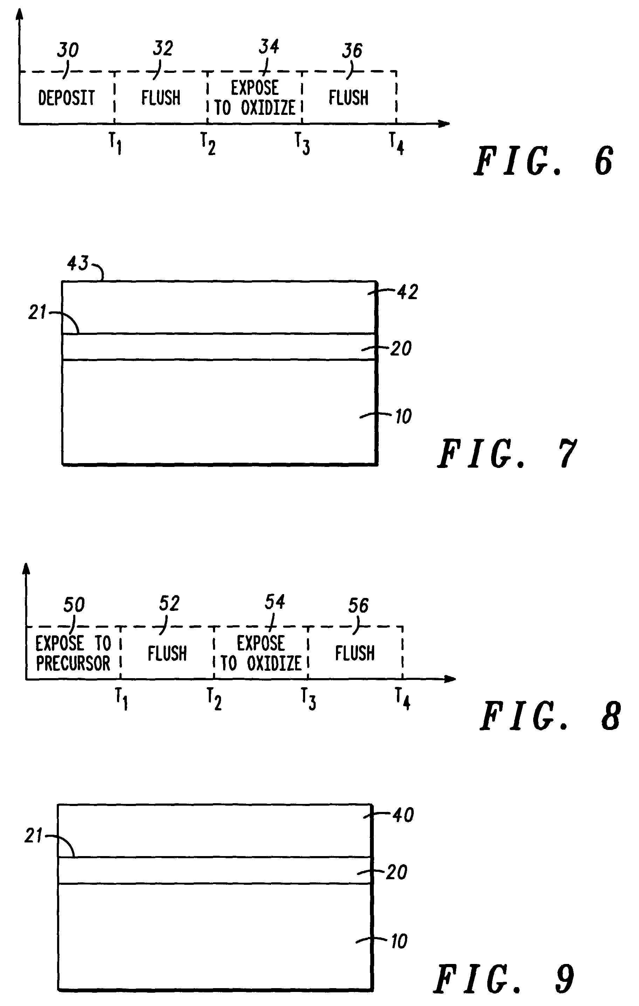

Referring now to FIGs. 7, 8, and 9, the formation of high dielectric constant oxide layer 40 is accomplished by atomic layer deposition. First, seed layer 20 is exposed 50 to a metal precursor, such as hafnium (Hf), strontium (Sr), zirconium (Zr), lanthanum (La), aluminum (Al), yttrium (Y), titanium (Ti), barium (Ba), lanthanum scandium (LaSc), or the like, during a time, T1, thereby forming a layer 42 on surface 21 of seed layer 20. Seed layer 20 is exposed 50 to the metal precursors at a temperature of generally between 100°C-500°, and in a preferred embodiment at a temperature of 250°C and at an atmospheric pressure of 0.5mTorr. A surface 43, of layer 42 is next flushed 52 with an inert gas, such as argon (Ar), nitrogen (N2) or helium (He) for a time, T2, to remove any excess metal precursor. Finally, the semiconductor structure is exposed 54 to oxygen (O₂) with or without plasma, water (H2O), nitrous oxide (N₂O), or nitric oxide (NO) for a time, T3, to oxidize layer 42, more particularly the metal precursor, forming high-k metal oxide layer 40, as illustrated in FIG. 9. It is disclosed that high-k metal oxide layer 40 thus includes at least one of a high dielectric constant oxide selected from the group of hafnium oxide (HfO₂), zirconium oxide (ZrO₂), strontium titanate (SrTiO₃), lanthanum oxide (La₂O₃), yttrium oxide (Y₂O₃), titanium oxide (TiO₂), barium titanate (BaTiO₃), lanthanum aluminate (LaAlO₃), lanthanum scandium oxide (LaScO₃) and aluminum oxide (Al₂O₃).

As a final step, layer 40 is flushed 56 with argon (Ar), nitrogen (N₂), helium (He) or the like, to remove any excess oxygen. This atomic layer deposition is repeated for a given number of cycles to form to form a high-k oxide of a desired thickness.

Accordingly, disclosed is a method for fabricating a thin, seed layer 20 with silicon 10 as been described herein using atomic layer deposition (ALD). This forcing of the formation of a silicate layer by atomic layer deposition provides for high precision control of the thickness and composition over large areas. In addition, conformity of growth in trenches is achieved. In each cycle of the deposition process, the migration of species is enhanced on the surface.

## Claims

1. A method of fabricating a semiconductor structure characterised by the steps of:
providing a silicon substrate (10) having a surface (12);
forming by atomic layer deposition a seed layer (20) on the surface of the silicon substrate; and
forming by atomic layer deposition one or more layers of a high dielectric constant oxide (40) on the seed layer.

2. A method of fabricating a semiconductor structure as claimed in claim 1 wherein the step of providing a substrate includes the step of providing a substrate having formed thereon a silicon oxide (14).

3. A method of fabricating a semiconductor structure as claimed in claim 2 wherein the step of forming by atomic layer deposition a seed layer further includes the step of depositing a layer of a metal oxide (18) onto a surface of the silicon oxide, flushing the layer of metal oxide with an inert gas, and reacting the metal oxide and the silicon oxide to form a silicate.

4. A method of fabricating a semiconductor structure as claimed in claim 1 wherein the step of providing a substrate includes providing a substrate having a layer (13) of hydrogen formed thereon by hydrogen passivation.

5. A method of fabricating a semiconductor structure as claimed in claim 4 wherein the step of forming by atomic layer deposition a seed layer (20) further includes the step of desorbing the layer (13) of hydrogen formed on the substrate, exposing (50) the silicon substrate to a silicon precursor and at least one metal precursor forming a layer of a silicon and a metal on the surface of the silicon substrate, flushing (52) the layer of silicon with an inert gas to remove any excess silicon and metal precursor material, exposing (54) the surface of the layer of silicon to at least one of oxygen (O₂) with or without plasma, water (H₂O), nitrous oxide (N₂O), or nitric oxide (NO) to oxidize the layer of silicon and metal thereby forming a single oxidized monolayer, and flushing (56) the oxidized monolayer with an inert gas.

6. A method of fabricating a semiconductor structure as claimed in claim 5 further including the step of repeating the atomic layer deposition to form monolayers.

7. A method of fabricating a semiconductor structure as claimed in claim 1 whereby the step of forming by atomic layer deposition one or more layers of a high dielectric constant oxide (42) includes the steps of exposing (50) the seed layer to a metal precursor, thereby forming a layer of metal, flushing (52) the layer of metal with an inert gas, exposing (54) the layer of metal to at least one of oxygen (O) with or without plasma, water (H2O), nitrous oxide (N₂O), or nitric oxide (NO) to oxidize the layer of metal thereby forming a single high-k oxidized monolayer, and flushing (56) the oxidized monolayer with an inert gas.

8. A method of fabricating a semiconductor structure as claimed in claim 7 further including the step of repeating the atomic layer deposition to form high-k oxide layer of a desired thickness.

9. A method of fabricating a semiconductor structure characterised by the steps of:
providing a silicon substrate (10) having a surface (12);
forming by atomic layer deposition a seed layer (20) on the surface of the silicon substrate, the seed layer formed of a silicate material; and
forming by atomic layer deposition one or more layers (42) of a high dielectric constant oxide on the seed layer.

10. A method of fabricating a semiconductor structure as claimed in claim 9 wherein the step of forming by atomic layer deposition the seed layer of a silicate material includes forming the seed layer of a silicate material selected from the group of strontium silicon oxide (SrSiO₄), zirconium silicon oxide (ZrSiO₄), and hafnium silicon oxide (HfSiO₄).

11. A method of fabricating a semiconductor structure as claimed in claim 10 wherein the step of forming by atomic layer deposition one or more layers of a high dielectric constant oxide on the seed layer includes forming the layer of high dielectric constant oxide selected from the group of hafnium oxide (HfO₂), zirconium oxide (ZrO₂), strontium titanate (SrTiO₃), lanthanum oxide (La₂O₃), yttrium oxide (Y₂O₃), titanium oxide (TiO₂), barium titanate (BaTiO₃), lanthanum aluminate (LaAlO₃), lanthanum scandium oxide (LaScO₃) and aluminum oxide (Al₂O₃).

12. A method of fabricating a semiconductor structure as claimed in claim 11 wherein the step of providing a substrate includes the step of providing a substrate having formed thereon a silicon oxide (14).

13. A method of fabricating a semiconductor structure as claimed in claim 12 wherein the step of forming by atomic layer deposition a seed layer further includes the step of depositing a layer (18) of a metal oxide onto a surface of the silicon oxide, flushing the layer of metal oxide with an inert gas, reacting the metal oxide with the silicon oxide to form the silicate selected from the group of strontium silicon oxide (SrSiO₄), zirconium silicon oxide (ZrSiO₄), and hafnium silicon oxide (HfSiO₄).

14. A method of fabricating a semiconductor structure as claimed in claim 11 wherein the step of providing a substrate includes providing a substrate having a layer (13) of hydrogen formed thereon by hydrogen passivation.

15. A method of fabricating a semiconductor structure as claimed in claim 14 wherein the step of forming by atomic layer deposition a seed layer further includes the step of desorbing the layer of hydrogen formed on the substrate, exposing (50) the silicon substrate to a silicon precursor and at least one metal precursor forming a layer of a silicon and a metal on the surface of the silicon substrate, flushing (52) the layer of silicon with an inert gas to remove any excess silicon and metal precursor material, exposing (54) the surface of the layer of silicon to at least one of oxygen (O₂) with or without plasma, water (H₂O), nitrous oxide (N₂O), or nitric oxide (NO) to oxidize the layer of silicon and metal thereby forming a single oxidized monolayer, and flushing (56) the oxidized monolayer with an inert gas.
